# EUROPEAN PATENT APPLICATION

(11) **EP 1 655 389 A1**
(43) Date of publication of application: **10.05.2006**
(21) Application number: 04747450.7
(22) Date of filing: 07.07.2004
(51) Int. Cl.: C23C 26/00

(54) **METAL LOADING METHOD AND DEVICE**

(30) Priority: 23.07.2003 JP 2003200625
(71) Applicant: FUJIKURA LTD., Kohtoh-ku, Tokyo 135-8512 (JP)
(72) Inventor: HIRAFUNE, Sayaka, c/o Fujikura Ltd., Tokyo 135-8512 (JP); SUEMASU, Tatsuo, c/o Fujikura Ltd., Tokyo 135-8512 (JP)
(74) Representative: Dr. Weitzel & Partner
(86) International application number: PCT/JP2004/009984
(87) International publication number: WO 2005/007931

(57) **Abstract**

A metal filling process is provided in which micro holes formed in a work piece are filled with metal by immersing the work piece in molten metal and then removing the work piece from the molten metal. As the work piece is dipped into molten metal, a bottom surface of the work piece is tilted to an angle of 0.5° or more relative to the surface of the molten metal, and as the work piece is removed from the molten metal, a top surface of the work piece is tilted to an angle of 0.5° or more and less than 85° relative to the surface of the molten metal. Failures such as a work piece fracturing when it is dipped into molten metal, or when it is removed from molten metal, are prevented, and failures such as metal remaining on a surface of a work piece after the work piece has been removed from molten metal are also prevented.

## Description

### TECHNICAL FIELD

The present invention relates to a metal filling process and metal filling apparatus that fill micro holes formed in a work piece with metal by inserting the work piece in molten metal so as to immerse the work piece in the molten metal, and by then removing the work piece from the molten metal.

### BACKGROUND ART

When forming via holes in a semiconductor substrate (i.e., a silicon substrate or the like) in a process to manufacture, for example, a silicon IC chip, a process is widely employed in which an electrode (i.e., a conductor) is created by forming holes in the substrate that penetrate (or do not penetrate) the substrate, and then filling these holes with molten metal. The molten metal is then cooled and hardened.

The applicants of the present invention have previously made an application for the technology described in Japanese Patent Application Unexamined Publication No. 2002-158191 (described below) as an example of a process for efficiently filling high aspect ratio micro holes with molten metal. In this process, in a decompressed atmosphere a work piece is dipped into molten metal so that the work piece is immersed in the molten metal. The atmosphere is then pressurized (i.e., the pressure is raised to a higher level than the level when the work piece was dipped into the molten metal, for example, to atmospheric pressure) resulting in micro holes formed in the work piece being filled with metal. Subsequently, the work piece is removed from the molten metal.

However, in the above described conventional technology, when a work piece is dipped into molten metal, and also when a work piece is removed from molten metal, both operations are performed with the angle of the surface of the work piece in a parallel state relative to the surface of the liquid molten metal.

As a result, in the case of a work piece having a thin plate thickness, when such a work piece is dipped into the molten metal and also when this work piece is removed from the molten metal, the problem arises that the work piece is sometimes broken because of pressing force which the work piece receives from the molten metal.

Moreover, in the conventional technology, after a work piece has been removed from molten metal, removing metal residue remaining on a surface of the work piece has also been a problem.

The present invention was conceived in order to solve the above problems and it is an object thereof to provide a metal filling process and a metal filling apparatus that prevent failures such as a work piece breaking when it is dipped into molten metal, or when it is removed from molten metal, and that also prevent failures such as metal remaining on a surface of a work piece after the work piece has been removed from molten metal.

### DISCLOSURE OF THE INVENTION

In order to achieve the above objects, the present invention is a metal filling process comprising immersing a plate shaped work piece with micro holes formed therein in molten metal and then removing the work piece from the molten metal to fill the micro holes with metal, wherein as the work piece is dipped into the molten metal, a bottom surface of the work piece is tilted to an angle of 0.5° or more relative to a surface of the molten metal.

According to this process, because a bottom surface of the work piece is tilted to an angle of 0.5° or more relative to the surface of the molten metal as the work piece is dipped into the molten metal, it is possible to prevent failures such as fractures in the work piece caused by pressing force received from the molten metal (i.e., the pressing force that acts on a work piece as a reaction force to the force generated by the work piece pushing the molten metal) when the work piece is dipped into the molten metal.

In addition, the present invention is a metal filling process comprising immersing a plate shaped work piece with micro holes formed therein in molten metal and then removing the work piece from the molten metal to fill the micro holes with metal, wherein as the work piece is removed from the molten metal, a top surface of the work piece is tilted to an angle of 0.5° or more and less than 85° relative to a surface of the molten metal.

According to this process, because a top surface of the work piece is tilted to an angle of 0.5° or more relative to the surface of the molten metal as the work piece is removed from the molten metal, it is possible to prevent failures such as fractures in the work piece caused by pressing force received from the molten metal when the work piece is removed from the molten metal. Moreover, it is possible to prevent failures such as metal remaining on a work piece surface after the work piece has been removed from the molten metal.

Moreover, because a surface of the work piece is tilted to an angle of less than 85° relative to the surface of the molten metal as the work piece is removed from the molten metal, it is possible to prevent failures such as the metal with which the micro holes formed in the work piece have been filled running out.

In addition, the present invention is a metal filling process comprising immersing a plate shaped work piece with micro holes formed therein in molten metal and then removing the work piece from the molten metal to fill the micro holes with metal, wherein a dipping operation of the work piece in the molten metal is begun with a bottom surface of the work piece tilted relative to a molten metal surface and, as the dipping operation progresses, an angle of the bottom surface of the work piece relative to the molten metal surface is made gradually parallel to the molten metal surface, and, thereafter, a top surface of the work piece is gradually tilted relative to the molten metal surface as the work piece is being taken out from the molten metal.

According to this process, it is possible to immerse the work piece in the molten metal even if there is only a small quantity of molten metal contained in the tank containing the molten metal (i.e., the molten metal tank), and temperature control of a heater that melts the metal is simplified. In addition, because a reduction in the chamber size can be achieved, further advantages are obtained such as control of the pressure (i.e., atmospheric pressure) inside the chamber being simplified.

In addition, in the present invention, it is also possible that after the work piece has been taken out of the molten metal, the work piece is vibrated such that metal adhering to a surface of the work piece is removed.

According to this process, an effect is obtained by vibrating the work piece that metal adhering to its surface is dropped off, and an advantage is obtained as well that bubbles which remained inside metal at the time of filling metal in the micro holes formed in the work piece are removed from the metal by the vibration of the work piece.

In addition, the present invention is a metal filling apparatus that fills micro holes formed in a plate shaped work piece with metal by immersing the work piece in molten metal and then removing the work piece from the molten metal, comprising a configuration whereby as the work piece is dipped into the molten metal, a bottom surface of the work piece is tilted to an angle of 0.5° or more relative to a surface of the molten metal.

According to this structure, because a bottom surface of the work piece is tilted to an angle of 0.5° or more relative to the surface of the molten metal as the work piece is dipped into the molten metal, it is possible to prevent failures such as fractures in the work piece caused by pressing force received from the molten metal when the work piece is dipped into the molten metal.

In addition, the present invention is a metal filling apparatus that fills micro holes formed in a plate shaped work piece with metal by immersing the work piece in molten metal and then removing the work piece from the molten metal, comprising a configuration whereby as the work piece is removed from the molten metal, a top surface of the work piece is tilted to an angle of 0.5° or more and less than 85° relative to a surface of the molten metal.

According to this structure, because a top surface of the work piece is tilted to an angle of 0.5° or more relative to the surface of the molten metal as the work piece is removed from the molten metal, it is possible to prevent failures such as fractures in the work piece caused by pressing force received from the molten metal when the work piece is removed from the molten metal. Moreover, it is possible to prevent failures such as metal remaining on a work piece surface after the work piece has been removed from the molten metal.

Moreover, because a surface of the work piece is tilted to an angle of less than 85° relative to the surface of the molten metal as the work piece is removed from the molten metal, it is possible to prevent failures such as the metal with which the micro holes formed in the work piece have been filled running out of the holes.

In addition, the present invention is a metal filling apparatus that fills micro holes formed in a plate shaped work piece with metal by immersing the work piece in molten metal and then removing the work piece from the molten metal, comprising a configuration whereby as the work piece is dipped into the molten metal, a bottom surface of the work piece is tilted to an angle of 0.5° or more relative to a surface of the molten metal, and as the work piece is removed from the molten metal, a top surface of the work piece is tilted to an angle of 0.5° or more and less than 85° relative to the surface of the molten metal.

According to this structure, because a bottom surface of the work piece is tilted to an angle of 0.5° or more relative to the surface of the molten metal as the work piece is dipped into the molten metal, it is possible to prevent failures such as fractures in the work piece caused by pressing force received from the molten metal when the work piece is dipped into the molten metal.

In addition, because a top surface of the work piece is tilted to an angle of 0.5° or more relative to the surface of the molten metal as the work piece is removed from the molten metal, it is possible to prevent failures such as fractures in the work piece caused by pressing force received from the molten metal when the work piece is removed from the molten metal. Moreover, it is possible to prevent failures such as metal remaining on a work piece surface after the work piece has been removed from the molten metal.

Moreover, because a surface of the work piece is tilted to an angle of less than 85° relative to the surface of the molten metal as the work piece is removed from the molten metal, it is possible to prevent failures such as the metal, with which the micro holes formed in the work piece have been filled, running out.

In addition, the present invention is a metal filling apparatus that fills micro holes formed in a plate shaped work piece with metal by immersing the work piece in molten metal and then removing the work piece from the molten metal, comprising a configuration whereby a dipping operation of the work piece in the molten metal is begun with a bottom surface of the work piece tilted relative to a molten metal surface and, as the dipping operation progresses, an angle of the bottom surface of the work piece relative to the molten metal surface is made gradually parallel to the molten metal surface, and, thereafter, a top surface of the work piece is gradually tilted relative to the molten metal surface as the work piece is being taken out from the molten metal.

According to this structure, it is possible to immerse the work piece in the molten metal even if there is only a small quantity of molten metal contained in the tank containing the molten metal (i.e., the molten metal tank), and temperature control of a heater that melts the metal is simplified. In addition, because a reduction in the chamber size can be achieved, further advantages are obtained such as control of the pressure (i.e., atmospheric pressure) inside the chamber being simplified.

### BRIEF DESCRIPTION OF THE DRAWINGS

FIG 1 is an overall view showing a metal filling apparatus according to an embodiment of the present invention.
FIGS. 2A and 2B are views showing in detail a jig according to an embodiment of the present invention.
FIGS. 3A and 3B are views showing a base of a jig according to an embodiment of the present invention.
FIG 4 is a view showing a specific example of a work piece according to an embodiment of the present invention.
FIG 5 is a view showing a specific example of a work piece according to an embodiment of the present invention.
FIG 6 is a process diagram of the metal filling process according to an embodiment of the present invention.
FIG 7 is a process diagram of the metal filling process according to an embodiment of the present invention.
FIG 8 is a process diagram of the metal filling process according to an embodiment of the present invention.
FIG 9 is a process diagram of the metal filling process according to an embodiment of the present invention.
FIG 10 is a process diagram of the metal filling process according to an embodiment of the present invention.

### BEST MODE TO CARRY OUT THE INVENTION

An embodiment of the present invention will now be described with reference to the attached drawings.

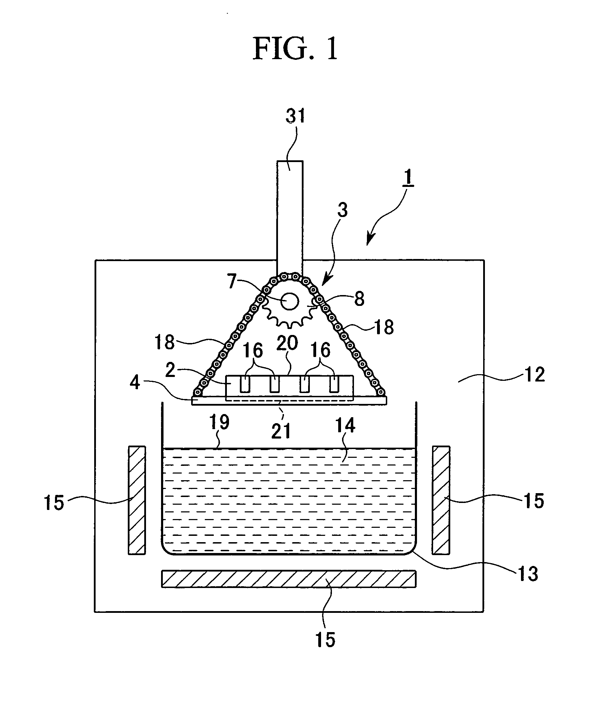

FIG 1 shows a metal filling apparatus 1 according to an embodiment of the present invention.

As is shown in FIG 1, in the metal filling apparatus 1 according to an embodiment of the present invention, a molten metal tank 13 is placed in a chamber 12, and molten metal 14 is put into the molten metal tank 13. A heater 15 that maintains the molten metal 14 in a molten state is provided around the molten metal tank 13. A jig 3 that supports a work piece 2 is provided above the molten metal tank 13. A raising/lowering apparatus (not shown) that raises and lowers the jig 3 and a decompression apparatus (not shown) that decompresses the interior of the chamber 12 are also provided in the chamber 12.

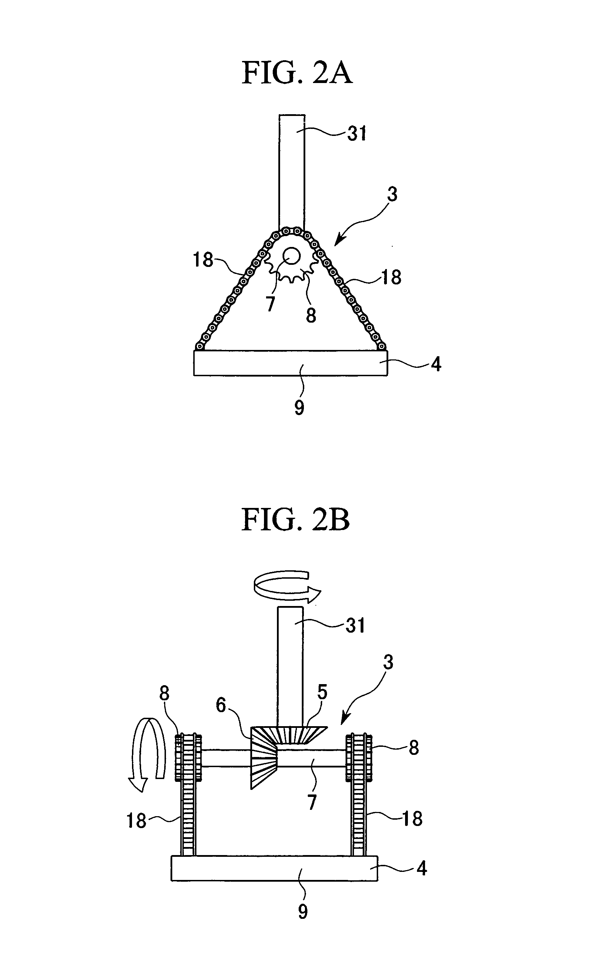

FIGS. 2A to 3B show the jig 3 used in the metal filling apparatus of an embodiment of the present invention. The jig 3 serves as a work piece (i.e., a substrate) support mechanism that supports the substrate 2.

Note that the jig 3 is used as a substrate support mechanism in the embodiment of the present invention, however, the jig 3 is only an example of a substrate support mechanism and various mechanisms capable of supporting the substrate 2 may be employed.

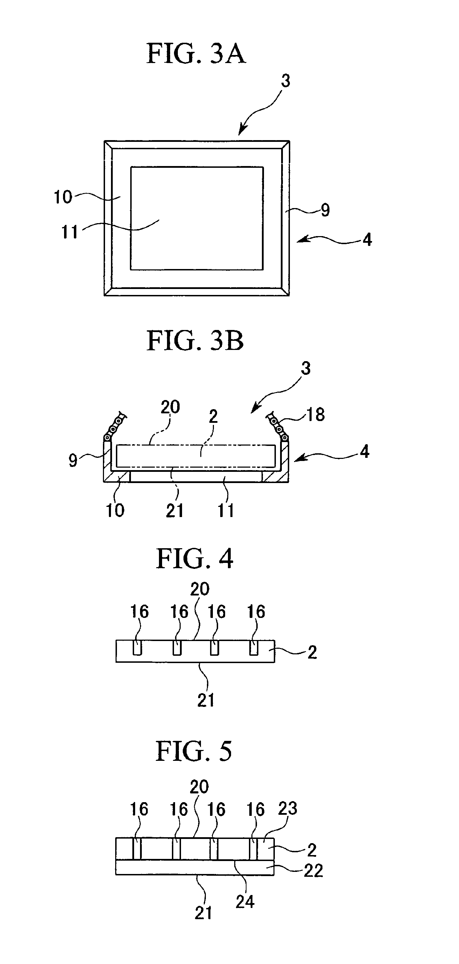

FIG. 2A is a front view showing the jig 3 in detail. FIG 2B is a side view showing the jig 3 in detail. FIG 3A is a plan view showing a base 4 of the jig 3, and FIG 3B is a cross-sectional side view showing the base 4 of the jig 3.

As is shown in FIGS. 2A and 2B, a first bevel gear 5 is rotated by a drive force from a power source (not shown). The rotation force thereof is transmitted to a second bevel gear 6 that is meshed with the first bevel gear 5. As a result, a drive shaft 7 that is formed integrally with the second bevel gear 6 is rotated, thereby causing arm support bodies 8 provided integrally with both ends of the drive shaft 7 to be rotated. This causes arms (i.e., base support bodies) 18 that support both end portions of the base 4 to move. As a result, the base 4 is placed in a tilted state. Here, the arms 18 have a chain form, however, belt form arms 18 may also be used.

The jig 3 is supported such that it can be moved upward or downward by a raising/lowering apparatus (not shown).

The jig 3 is able to be detached from a raising/ lowering member 31 that is raised or lowered by the raising/ lowering apparatus. Once detached from the raising/lowering member 31 it is able to be removed from the chamber 12 to the outside. When the jig 3 is mounted on the raising/ lowering member 31, rotation force from a power source outside the chamber 12 is transmitted via a drive force transmission mechanism provided on the raising/ lowering apparatus to a rotation shaft 5a of the first bevel gear 5 of the jig 3.

As is shown in FIGS. 3A and 3B, as seen in plan view, the base 4 has a rectangular configuration and is provided with an upright portion 9 that extends upwards, and a bottom support guide portion 10 that extends from underneath the upright portion 9 towards the inside. As seen in plan view, a wide gap 11 is formed in the center portion.

FIGS. 4 and 5 show specific examples of the substrate 2 used in embodiments of the present invention.

In FIG 4, the substrate 2 has a plurality of micro holes 16 that open at a top surface 20 of the substrate 2.

In contrast, in FIG 5, the substrate 2 (to simplify the explanation, this substrate may, in some cases, be given the symbol 2A) has a plurality of micro holes 16 that penetrate from the top surface 20 of the substrate 2A to a bottom surface 24. A sealing member 22 that seals the apertures of the micro holes 16 is provided on the bottom surface 24 side of the substrate 2. In the case of this substrate 2A, a substrate 2A having the sealing member 22 attached thereto is dealt with as the work piece of the present invention.

Here, the thickness of the substrate 2 is approximately 70 to 150 µm, and the diameter of the micro holes is 20 to 60 µm, however, the thickness of the substrate and the diameter of the micro holes are not limited to these dimensions, and substrate and micro holes having a variety of sizes can be used.

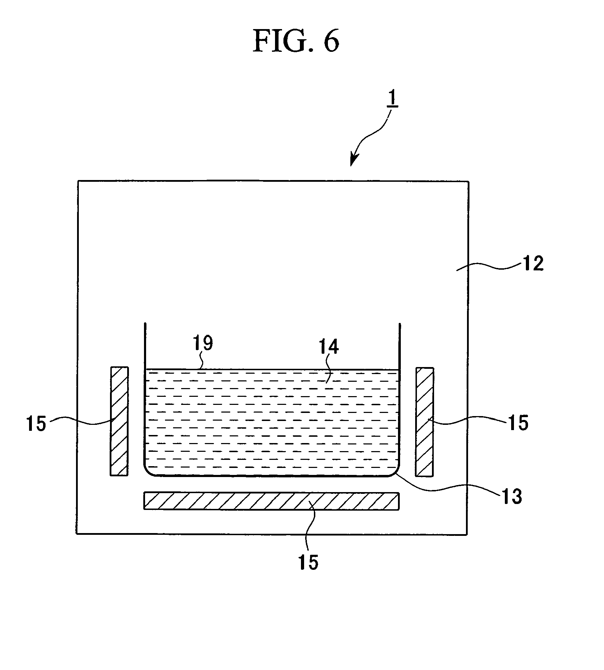

The procedure of the metal filling process according to the embodiments of the present invention will now be described with reference to FIGS. 6 to 10.

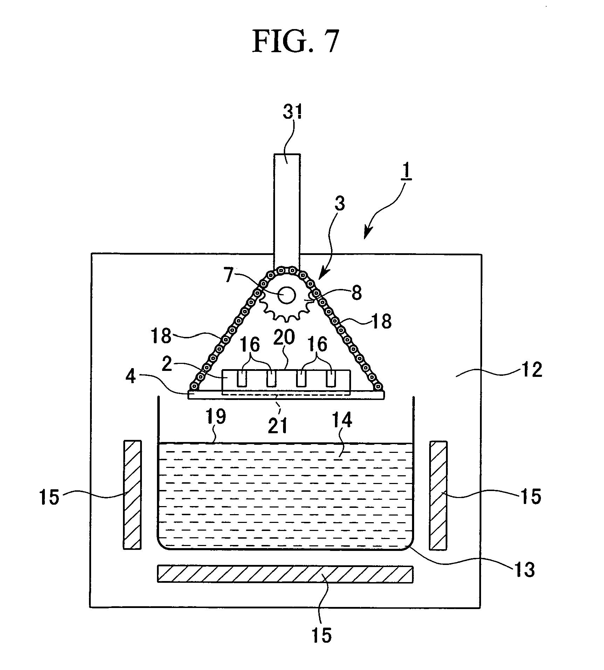

As is shown in FIG 7, a work piece (substrate) 2 in which micro holes 16 are formed is placed in the jig 3, namely, is placed on the base 4. The jig 3 with the substrate 2 in position on the base 4 is inserted into the chamber 12, and is attached to the raising/ lowering member 31 of the raising/ lowering apparatus. As a result, the substrate 2 is dipped into the chamber 12. The substrate 2 is placed on the base 4 such that the top surface 20 thereof faces upwards and the bottom surface 24 thereof faces downwards, and is then fixed in position by a fixing apparatus. The method employed to insert the substrate 2 inside the chamber 12 may also be one in which the substrate 2 is placed on the base 4 of the jig 3 while it is already being supported by the raising/lowering apparatus.

After the substrate 2 has been inserted inside the chamber 12, the interior of the chamber 12 is decompressed by the decompression apparatus (not shown).

Furthermore, the first bevel gear 5 is rotated by drive force from the power supply, thereby causing the two arms 18 to move via the second bevel gear 6, the drive shaft 7, and the arm support bodies 8. As a result, the base 4 supported by the arms 19 is tilted, and the substrate 2 supported by the base 4 is placed in a tilted state.

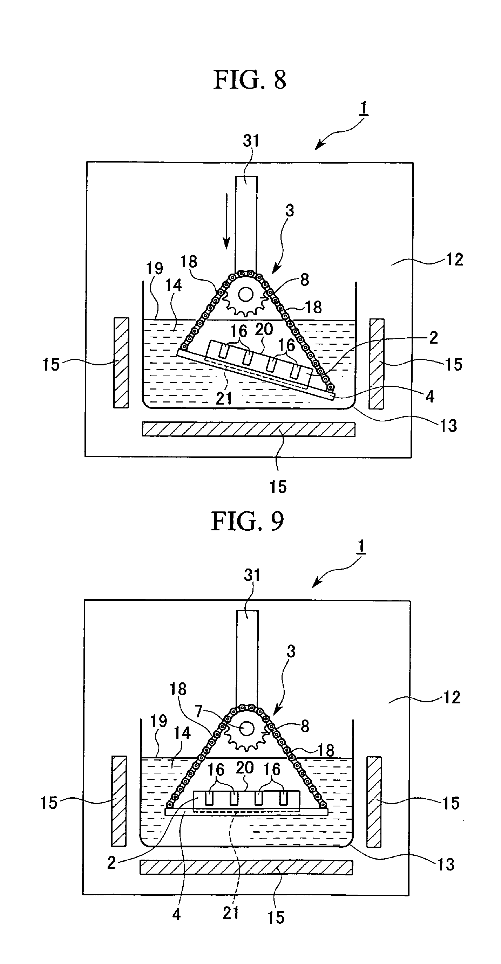

Next, as is shown in FIG. 8, by moving the jig 3 downwards, the substrate 2 placed on the jig 3 is dipped into the molten metal 14 in a tilted state relative to the liquid surface 19 of the molten metal that has been obtained by earlier melting metal using the heater 15.

Note that, in the above description, it is possible to first tilt the substrate 2 above the molten metal tank 13 and then insert it into the molten metal 14 while maintaining the tilt angle, however, the present embodiment is not limited to this, and it is also possible to tilt the substrate 2 while the substrate 2 is being moved downwards by the raising/lowering apparatus, so that when the substrate 2 arrives at the molten metal liquid surface 19 the substrate 2 is tilted relative to the molten metal liquid surface 19.

However, during the insertion operation, the tilt angle of the substrate 2 relative to the liquid surface of the molten metal 14 (this will be referred to below simply as the "tilt angle") is set at 0.5° or greater, and, preferably, at 5° or greater.

Accordingly, failures such as the substrate 2 being fractured by pressing force received from the molten metal 14 can be prevented. If the tilt angle at this time is greater than 5°, the pressing force that the substrate receives from the molten metal can be softened more effectively, enabling the problem of fractures to be more reliably prevented.

Note that in order for the rigidity and attitude of the base 4 and the arms 18 to be maintained when they are dipped into the molten metal 14, it is necessary for them to have a higher melting point than that of the molten metal, and also for them to have a higher specific gravity than that of the molten metal 14.

Next, as is shown in FIG 9, after the substrate 2 has been dipped inside the molten metal 14, by causing drive force from the power source to operate in reverse compared to its previous operation, the first bevel gear 5 is rotated in reverse and the two arms 18 are moved in reverse compared to their previous movement via the second bevel gear 6, the drive shaft 7, and the arm support bodies 8. As a result, the substrate 2 supported by the base 4 is placed in a horizontal state.

Note that the term "horizontal state" used here does not imply that a perfectly horizontal state is required, and includes states in which either the top surface or the bottom surface of the substrate 2 are substantially parallel to the surface of the molten metal 14. It is also possible for the tilt angle of the substrate 2 to be gradually changed to a horizontal state as the substrate 2 is being dipped inside the molten metal 14 by the lowering of the jig 3. In this case, the advantage is obtained that it is possible to completely immerse the substrate 2 in the molten metal 14 even if the quantity of molten metal 14 collected in the molten metal tank 13 is the same (or substantially the same) as when the substrate 2 is dipped into and immersed in the molten metal 14 in a horizontal state.

Subsequently, once the atmospheric pressure inside the chamber 12 is restored by a pressurizing apparatus (not shown), the micro holes in the substrate 2 are caused by differential pressure to be filled up by the molten metal 14 (i.e., differential pressure filling).

Note that, at this time, in order to achieve differential pressure filling, it is sufficient if the pressure after the immersion is increased over the pressure before the substrate 2 is dipped inside the molten metal 14, and the pressure inside the chamber 12 after the immersion does not necessarily need to be equivalent to atmospheric pressure.

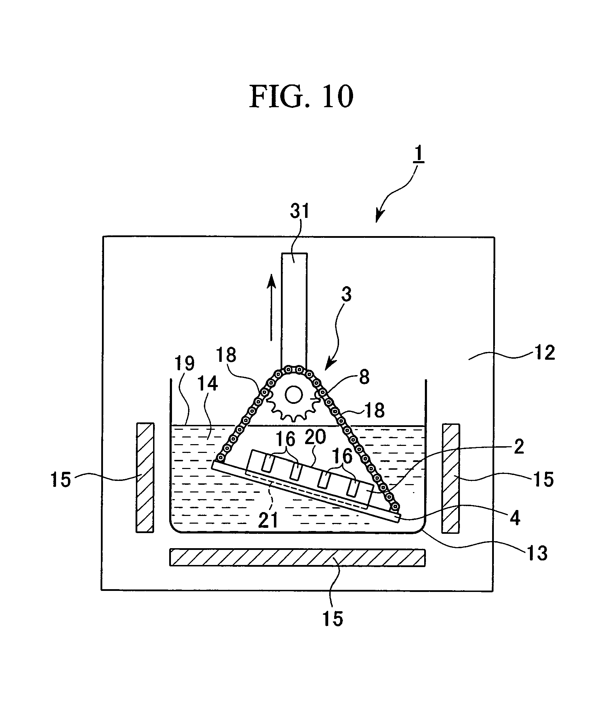

Next, as is shown in FIG. 10, the first bevel gear 5 is rotated by drive force from the power source, causing the two arms 18 to be moved via the second bevel gear 6, the drive shaft 7, and the arm support bodies 8. As a result, the base 4 that is supported by the arms 18 is tilted and the substrate 2 that is supported by the base 4 is placed in a tilted state inside the molten metal 14. In this manner, by raising the jig 3 while the substrate 2 is in a tilted state, the substrate 2 can be lifted.

Here, the substrate 2 is lifted up while it is in a tilted state, however, it is also possible to lift the substrate 2 up from the molten metal 14 while gradually tilting the substrate surface 20 relative to the molten metal liquid surface 19.

The substrate 2 is lifted such that the top surface 20 is facing upwards.

During the operation to lift the substrate 2 from the molten metal 14, the tilt angle of the substrate 2 is set to a range of 0.5° or greater and less than 85°, and, more preferably, in a range of 5° to 75°.

If the tilt angle is set within this range, molten metal 14 can be prevented from running out from the micro holes 16, and molten metal 14 can be dropped from the substrate top surface 20. If the tilt angle during the lifting operation is less than 0.5°, molten metal 14 residue on the substrate 2 increases making it necessary to perform a process to remove the molten metal 14 such as temporarily increasing the tilt angle during the lifting operation or imparting a vibration or the like to the substrate 2 (described below). If the tilt angle exceeds 85°, the molten metal 14 with which the micro holes 16 have been filled tends to run out from the micro holes 16. Consequently, it is necessary to maintain the attitude of the substrate 2 such that the tilt angle does not exceed 85° both during the lifting operation and after the lifting operation until the molten metal 14 cools and solidifies.

Moreover, prior to the metal cooling and solidifying, by causing the substrate to vibrate using ultrasonic waves or the like from an ultrasonic wave generator functioning as a vibration mechanism, it is possible to shake off metal remaining on the substrate surface 20.

It is also possible to use a variety of non-contact types of vibration mechanism other than an ultrasonic wave generator as the vibration mechanism.

If an ultrasonic wave generator is used as the vibration mechanism then, for example, the vibration may be imparted by ultrasonic waves having a frequency of 40 kHz and an amplitude of 3 µm.

After the metal has been cooled the substrate 2 is removed from the chamber 12 and the process is ended.

Specific examples of the present invention are given below.

Example 1 is described first.

Blind via holes (non-penetrating, micro holes) 16 having an aspect ratio (hole length/ hole diameter) of 3 and a hole diameter of 40 µm were formed by Deep-RIE in a Si wafer (i.e., in a silicon substrate serving as the work piece (substrate) 2) having a thickness of 150 µm. Here, a Si wafer is used as the substrate 2, however, the material of the substrate 2 may also be any one of glass, ceramic, resin, or metal. The hole forming method is also optional. Subsequently, an oxidized film (an SiO₂ film) was formed on the surface of the substrate, and the substrate 2 was then set in the jig 3. Next, the substrate 2 was inserted inside the chamber 12 and the pressure inside the chamber 12 was decompressed to approximately 5 Pa.

After the decompression, the substrate 2 was tilted by moving the arms 18, and was dipped into molten metal 14, being a mixture of Au-Sn 20 percent by weight, at a tilt angle of 15° relative to the molten metal surface 19. The material for the arms 18 and base 4 used here was manufactured from SUS. After the arms 18 were completely dipped into the molten metal 14 the substrate 2 was positioned parallel to the molten metal surface 19. After this dipping, the interior of the chamber 12 was restored to atmospheric pressure. Approximately 10 minutes later, after the substrate 2 had been tilted 15°, the substrate 2 was lifted out from the molten metal 14. After the metal was then cooled, the substrate 2 was removed from the chamber 12. When the substrate 2 was inspected it was found that there was no metal residue on the substrate surface 20, and that there were no failures such as fractures in the substrate 2.

Example 2 is described next.

Using the same method as in Example 1 a substrate 2 was set in the chamber 12, and the substrate 2 was then positioned at a tilt angle of 15° relative to the molten metal surface 19. The substrate 2 was then dipped into the molten metal 14. During this process, the substrate 2 was dipped into the molten metal 14 as the tilt angle of the substrate 2 was gradually made parallel to the molten metal surface 19 while ensuring that the substrate 2 did not come out of the molten metal 14. Next, in the same manner as in Example 1, after the micro holes 16 in the substrate 2 were filled with molten metal 14, an operation to lift the substrate 2 from the molten metal surface 19 was begun while the substrate 2 was kept at a tilt angle of 2° relative to the molten metal surface 19. The tilt angle of the substrate 2 was then gradually made larger and was continued until the tilt angle of the substrate 2 relative to the molten metal surface 19 was 60°. The substrate 2 was then lifted out of the molten metal 14. Thereafter, when the substrate 2 was inspected it was found that there was no metal residue on the substrate surface 20, and that there were no fractures or the like in the substrate 2.

Comparative example 1 will now be described.

In Example 1, when dipping the substrate 2 into the molten metal 14, the substrate 2 was kept parallel with the molten metal surface 19. When the substrate 2 was then lifted from the molten metal 14 and inspected, it was found that there were fractures in the substrate 2.

Comparative example 2 will now be described.

In Example 1, when removing the substrate 2 from the molten metal 14, the substrate 2 was kept parallel with the molten metal surface 19. After the substrate 2 was removed from the molten metal 14 it was tilted at an angle of 15°. However, upon inspection it was found that metal lumps remained in places on the substrate surface 20.

Comparative example 3 will now be described.

In Example 1, when the substrate 2 was removed from the molten metal 14, this was performed with the substrate 2 at a tilt angle of 90°. When the substrate 2 was inspected, it was found that there was no metal residue on the substrate surface 20, and that there were no fractures or the like in the substrate 2. However, metal had run off from the micro holes 16.

In the above described embodiment a structure is described in which a work piece (i.e., a substrate) support mechanism that supports a work piece also functions as a work piece tilting mechanism that adjusts a tilt angle of a top surface or bottom surface of a work piece relative to a molten metal surface by tilting the work piece. However, in the present invention, the structure is not limited to this and it is also possible, for example, to employ a structure in which a tilting mechanism separate from the work piece support mechanism is provided in the chamber.

The metal filling apparatus of the present invention can also employ a structure in which a control apparatus that controls a drive of a power source is provided in a work piece support mechanism (for example, the work piece support mechanism described in the above embodiment) that has a function of being able to alter the tilt angle of a work piece using the drive of the power source. Consequently, either one of or both of the tilt angle of the work piece when it is dipped into the molten metal and the tilt angle of the work piece when it is lifted out of the molten metal is set to a desired angle (i.e., a tilt angle of 0.5° or more when inserting a work piece and a tilt angle of 0.5° to 85° when lifting out the work piece) by the control of the control apparatus.

A work piece used in the present invention is not limited to the above described substrate, and a variety of items may be used.

### INDUSTRIAL APPLICABILITY

As has been described above, in the present invention, because a bottom surface of a work piece is tilted by 0.5° or more relative to a molten metal surface when the work piece is dipped into the molten metal, as a result of the piece receiving pressing force from the molten metal when it is dipped into the molten metal, defects such as the work piece fracturing can be prevented.

Moreover, in the present invention, because a top surface of the work piece is tilted to an angle of 0.5° or more relative to a molten metal surface when the work piece is removed from the molten metal, as a result of the work piece receiving pressing force from the molten metal when it is removed from the molten metal, defects such as the work piece fracturing can be prevented. Furthermore, after the work piece has been removed from the molten metal, defects such as metal remaining on the surface of the work piece can be prevented.

In addition, because a surface of the work piece is tilted to an angle of less than 85° relative to a molten metal surface when the work piece is removed from the molten metal, failures such as the metal with which the micro holes formed in the work piece have been filled running out can be prevented.

Furthermore, in the present invention, the bottom surface of a work piece is tilted relative to the molten metal surface. Dipping of the work piece in the molten metal is then begun and, as the dipping operation progresses, the angle of the work piece bottom surface relative to the molten metal surface is made gradually parallel to the molten metal surface. Thereafter, the top surface of the work piece is gradually tilted further relative to the molten metal surface as the work piece is being taken out from the molten metal. As a result, it is possible to immerse the work piece in the molten metal even if there is only a small quantity of molten metal contained in the tank containing the molten metal (i.e., the molten metal tank), and temperature control of a heater that melts the metal is simplified. Because a reduction in the chamber size can be achieved, further advantages are obtained such as control of the pressure (i.e., atmospheric pressure) inside the chamber being simplified.

## Claims

1. A metal filling process comprising immersing a plate shaped work piece with micro holes formed therein in molten metal and then removing said work piece from said molten metal to fill said micro holes with metal, wherein
as said work piece is dipped into said molten metal, a bottom surface of said work piece is tilted to an angle of 0.5° or more relative to a surface of said molten metal.

2. A metal filling process comprising immersing a plate shaped work piece with micro holes formed therein in molten metal and then removing said work piece from said molten metal to fill said micro holes with metal, wherein
as said work piece is removed from said molten metal, a top surface of said work piece is tilted to an angle of 0.5° or more and less than 85° relative to a surface of said molten metal.

3. A metal filling process comprising immersing a plate shaped work piece with micro holes formed therein in molten metal and then removing said work piece from said molten metal to fill said micro holes with metal, wherein
a dipping operation of said work piece in said molten metal is begun with a bottom surface of said work piece tilted relative to a molten metal surface and, as said dipping operation progresses, an angle of said bottom surface of said work piece relative to said molten metal surface is made gradually parallel to said molten metal surface, and, thereafter, a top surface of said work piece is gradually tilted relative to said molten metal surface as said work piece is being taken out from said molten metal.

4. The metal filling process according to any of claims 1 to 3, further comprising vibrating said work piece after said work piece has been taken out of said molten metal such that metal adhering to a surface of said work piece is removed.

5. The metal filling process according to any of claims 1 to 3, further comprising vibrating said work piece after the work piece has been taken out of said molten metal such that bubbles present inside the metal in said micro holes are removed.

6. A metal filling apparatus that fills micro holes formed in a plate shaped work piece with metal by immersing said work piece in molten metal and then removing said work piece from said molten metal, comprising a configuration whereby
as said work piece is dipped into said molten metal, a bottom surface of said work piece is tilted to an angle of 0.5° or more relative to a surface of said molten metal.

7. A metal filling apparatus that fills micro holes formed in a plate shaped work piece with metal by immersing said work piece in molten metal and then removing said work piece from said molten metal, comprising a configuration whereby
as said work piece is removed from said molten metal, a top surface of said work piece is tilted to an angle of 0.5° or more and less than 85° relative to a surface of said molten metal.

8. A metal filling apparatus that fills micro holes formed in a plate shaped work piece with metal by immersing said work piece in molten metal and then removing said work piece from said molten metal, comprising a configuration whereby
as said work piece is dipped into said molten metal, a bottom surface of said work piece is tilted to an angle of 0.5° or more relative to a surface of said molten metal, and as said work piece is removed from said molten metal, a top surface of said work piece is tilted to an angle of 0.5° or more and less than 85° relative to said surface of said molten metal.

9. A metal filling apparatus that fills micro holes formed in a plate shaped work piece with metal by immersing said work piece in molten metal and then removing said work piece from said molten metal, comprising a configuration whereby
a dipping operation of said work piece in said molten metal is begun with a bottom surface of said work piece tilted relative to a molten metal surface and, as said dipping operation progresses, an angle of said bottom surface of said work piece relative to said molten metal surface is made gradually parallel to said molten metal surface, and, thereafter, a top surface of said work piece is gradually tilted relative to said molten metal surface as said work piece is being taken out from said molten metal.
